Europäisches Patentamt

European Patent Office

Office européen des brevets

(19)

(11) **EP 1 507 968 B1**

(12) **EUROPÄISCHE PATENTSCHRIFT**

(45) Veröffentlichungstag und Bekanntmachung des Hinweises auf die Patenterteilung:
**21.12.2005 Patentblatt 2005/51**

(21) Anmeldenummer: 03755080.3

(22) Anmeldetag: **19.05.2003**

(51) Int Cl.7: **F02D 41/20**

(86) Internationale Anmeldenummer:
**PCT/DE2003/001613**

(87) Internationale Veröffentlichungsnummer:
**WO 2003/100235 (04.12.2003 Gazette 2003/49)**

(54) **VERFAHREN ZUR ANSTEUERUNG EINES AKTORS UND ZUGEHÖRIGE STEUEREINRICHTUNG**

METHOD FOR CONTROLLING AN ACTUATOR AND CONTROL DEVICE BELONGING THERETO

PROCEDE DE COMMANDE D'UN ACTIONNEUR ET DISPOSITIF COMMANDE ASSOCIE

(84) Benannte Vertragsstaaten:
**DE FR GB IT**

(30) Priorität: **27.05.2002 DE 10223553**

(43) Veröffentlichungstag der Anmeldung:
**23.02.2005 Patentblatt 2005/08**

(73) Patentinhaber: SIEMENS
**AKTIENGESELLSCHAFT
80333 München (DE)**

(72) Erfinder:
• **CHEMISKY, Eric
F-67630 Lauterbourg (FR)**
• **SCHROD, Walter
93057 Regensburg (DE)**

(56) Entgegenhaltungen:
EP-A- 1 138 903          EP-A- 1 138 915
EP-A- 1 139 446          DE-A- 19 944 733
US-A1- 2002 046 731

EP 1 507 968 B1

## Beschreibung

Die Erfindung betrifft ein Verfahren zur elektrischen Ansteuerung eines Aktors, insbesondere eines piezoelektrischen Aktors einer Einspritzanlage für eine Brennkraftmaschine, gemäß dem Oberbegriff des Anspruchs 1 sowie eine entsprechende Steuereinrichtung gemäß dem Oberbegriff des Anspruchs 10.

In modernen Einspritzanlagen für Brennkraftmaschinen werden in den Injektoren zunehmend piezoelektrische Aktoren eingesetzt, um den Kraftstoff in die Brennräume einzuspritzen. Derartige piezoelektrische Aktoren benötigen Spannungen im Bereich von 120-400 Volt, so dass zur elektrischen Ansteuerung der piezoelektrischen Aktoren beispielsweise getaktete Schaltnetzteile eingesetzt werden können, die aus der Bordspannung von üblicherweise 12, 24 oder 42 Volt die erforderliche Spannung für die Aktoren erzeugen.

Aus DE 199 44 733 A1 ist ein derartiges Schaltnetzteil bekannt, das zur Spannungswandlung einen Transformator aufweist und den Aktor in einer Ladephase auflädt und anschließend in einer Entladephase wieder entlädt, um die gewünschte Stellbewegung des Aktors zu erzeugen. Nach der Ladephase wird hierbei eine konstante Verzögerungszeit abgewartet, bis mit dem Entladevorgang begonnen wird, damit der Transformator zu Beginn des Entladevorgangs mit Sicherheit leer ist.

Nachteilig an derartigen getakteten Schaltnetzteilen ist jedoch die Tatsache, dass die Ausgangsenergie und damit die Einspritzmenge große Quantisierungssprünge aufweist, was unter anderem durch die mit der Taktung verbundene zeitliche Rasterung verursacht wird. Die Quantisierung bei der Aktoransteuerung hat also eine Quantisierung der eingespritzten Kraftstoffmenge zur Folge, was dem Ziel einer möglichst präzisen Ansteuerung der Brennkraftmaschine widerspricht und mit unerwünschten Abgasemissionen verbunden ist.

Das Dokument EP-A-1 138 903 beschreibt ein Verfahren gemäß dem Oberbegriff des Anspruchs ein.

Der Erfindung liegt deshalb die Aufgabe zugrunde, ein Verfahren zur elektrischen Ansteuerung eines Aktors und eine entsprechende Steuereinrichtung zu schaffen, wobei Quantisierungssprünge möglichst vermieden werden sollen.

Die Aufgabe wird hinsichtlich des Verfahrens durch die Merkmale des Anspruchs 1 und bezüglich einer entsprechenden Steuereinrichtung durch die Merkmale des Anspruchs 10 gelöst.

Die Erfindung umfasst die allgemeine technische Lehre, die Verzögerungszeit zwischen der Ladephase und der Entladephase variabel festzulegen, um die Quantisierungssprünge auszugleichen, die durch die Zeitrasterung verursacht werden.

Falls beispielsweise das Entladesignal kurz nach dem Beginn eines Zeitrasters erscheint, so verschiebt sich der Bezugspunkt für den Beginn der Entladephase bis zum Ende dieses Zeitrasters, was bei einer herkömmlichen Ansteuerung zu einem großen Quantisierungssprung führen würde. In diesem Fall sieht die Erfindung vorzugsweise eine relativ kleine Verzögerungzeit vor, um den Quantisierungssprung auszugleichen, der mit der zeitlichen Verschiebung des Bezugspunktes für die Entladephase verbunden ist. In diesem Fall ist die Verzögerungszeit vorzugsweise relativ kurz im Vergleich zu dem Zeitraster.

Falls das Entladesignals dagegen kurz vor dem Ende eines Zeitrasters auftritt, so führt die Verschiebung des Bezugspunktes für den Beginn der Entladephase nur zu einem sehr geringen Quantisierungssprung. In diesem Fall sieht die Erfindung vorzugsweise eine relativ große Verzögerungszeit bis zum Beginn der Entladephase vor, um die Quantisierungssprünge unabhängig von der zeitlichen Lage des Entladesignals möglichst gering zu halten. In diesem Fall ist die Verzögerungszeit vorzugsweise relativ groß im Vergleich zu dem Zeitraster und kann beispielsweise der Dauer von zwei Zeitrastern entsprechen.

In der bevorzugten Ausführungsform der Erfindung wird die Verzögerungszeit also in Abhängigkeit von der zeitlichen Lage des Entladesignals variabel festgelegt.

Vorzugsweise wird hierbei der zeitliche Abstand zwischen dem Entladesignal und dem Beginn des vorangegangenen Ladeimpulses ermittelt, wobei die Verzögerungszeit in Abhängigkeit von diesem Zeitabstand festgelegt wird. Dabei wird davon ausgegangen, dass die Periodendauer der Ladeimpulse die Zeitrasterung bestimmt, so dass der Beginn eines Ladeimpulses jeweils mit dem Beginn eines Zeitrasters zusammenfällt.

Hierbei weist die Verzögerungszeit vorzugsweise eine lineare Abhängigkeit von der Zeitspanne zwischen dem Entladesignal und dem Beginn des vorangegangenen Ladeimpulses auf, wobei die Verzögerungszeit vorzugsweise linear mit der Zeitspanne zwischen dem Entladesignal und dem Beginn des vorangegangenen Ladeimpulses zunimmt.

Vorzugsweise weist die Verzögerungszeit hierbei unabhängig von der zeitlichen Lage des Entladesignals einen Minimalwert auf, der sicherstellen soll, dass der Transformator in dem Schaltnetzteil vor Beginn der Entladephase entleert ist. Der Minimalwert der Verzögerungszeit liegt beispielsweise im Bereich von einem bis zehn Zeitrastern, wobei beliebige Zwischenwerte möglich innerhalb dieses Bereichs möglich sind.

Darüber hinaus kann die Verzögerungszeit auch eine andere funktionale Abhängigkeit von der Zeitspanne zwischen dem Entladesignal und dem vorangegangenen Ladeimpuls aufweisen. Beispielsweise kann die funktionale Abhängigkeit proportional, progressiv oder degressiv sein, um den Ausgleich der durch die Zeitrasterung bedingten Quantisierungssprünge zu optimieren.

Die Verzögerungszeit beginnt hierbei vorzugsweise jeweils mit dem Beginn des letzten Ladeimpulses, jedoch kann die Verzögerungszeit auch mit dem Entladesignal gestartet werden.

In der bevorzugten Ausführungsform der Erfindung wird das Entladesignal durch eine fallende Flanke eines Steuersignals gebildet, wohingegen die steigende Flanke des Steuersignals ein Ladesignal bildet.

Darüber hinaus umfasst die Erfindung auch eine Steuereinrichtung zur Durchführung des vorstehend beschriebenen erfindungsgemäßen Verfahrens.

Hierzu weist die erfindungsgemäße Steuereinrichtung einen Signaleingang auf, an dem das Entladesignal aufgenommen wird.

Weiterhin weist die erfindungsgemäße Steuereinrichtung einen Signalausgang auf, um ein Steuersignal abzugeben, das die Entladephase startet, indem beispielsweise ein Entladetransistor des Schaltnetzteils durchschaltet.

Die Ausgabe des Steuersignals wird hierbei durch ein Verzögerungsglied um eine vorgegebene Verzögerungszeit verzögert, wobei das Verzögerungsglied eine variable Verzögerungszeit aufweist, um die Auswirkungen von Quantisierungssprüngen durch eine Anpassung der Verzögerungszeit auszugleichen.

Vorzugsweise ist die Verzögerungszeit von dem Zeitabstand zwischen dem Entladesignal und dem Beginn des vorangegangenen Ladeimpulses abhängig. Zur Ermittlung dieses Zeitabstands ist vorzugsweise ein Zähler vorgesehen, der jeweils mit dem Beginn eines Ladeimpulses synchronisiert wird und ausgangsseitig eine Impulszahl ausgibt, die die Zeitspanne seit dem Beginn des letzten Ladeimpulses wiedergibt. Beim Erscheinen des Entladesignals übernimmt das Verzögerungsglied diese Impulszahl dann als Verzögerungszeit.

Das Verzögerungsglied selbst weist vorzugsweise einen weiteren Zähler auf, der die Impulse eines Taktsignals zählt und beim Erreichen einer vorgegebenen Unter- oder Obergrenze den Entladevorgang startet.

Andere vorteilhafte Weiterbildungen der Erfindung sind in den Unteransprüche enthalten oder werden nachstehend zusammen mit der Beschreibung des bevorzugten Ausführungsbeispiels der Erfindung anhand der Zeichnungen erläutert. Es zeigen:

Figur 1   die erfindungsgemäße Steuereinrichtung als Blockschaltbild,

Figur 2   das erfindungsgemäße Verfahren zur Ansteuerung eines Aktors als Flussdiagramm,

Figur 3   ein Impulsdiagramm zur Verdeutlichung des erfindungsgemäßen Verfahrens sowie

Figur 4   ein Impulsdiagramm zur Verdeutlichung der variablen Festlegung der Verzögerungszeit bei dem erfindungsgemäßen Verfahren.

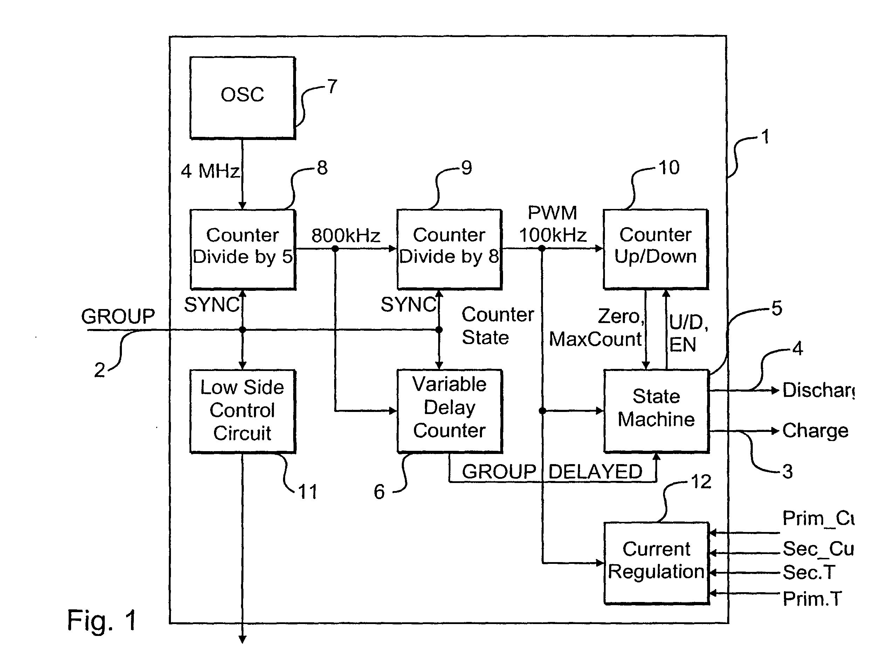

Das Blockschaltbild in Figur 1 zeigt eine Steuereinrichtung 1 zur Steuerung des Lade- und Entladevorgangs eines piezoelektrischen Aktors einer Einspritzanlage für eine Brennkraftmaschine, um den gewünschten Hub des Aktors einzustellen und Einspritzzeitpunkt und Einspritzdauer festzulegen.

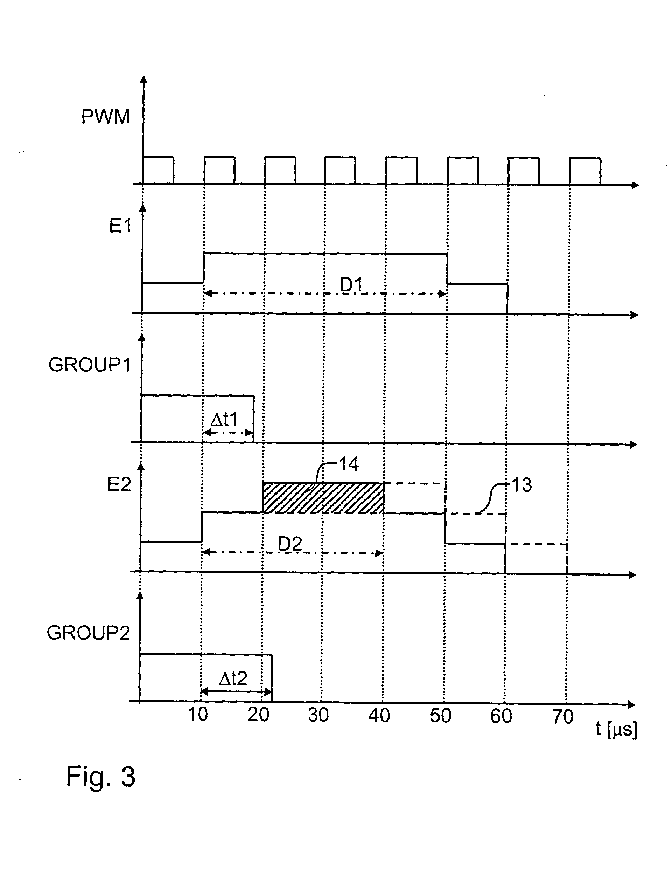

Die Festlegung des Einspritzzeitpunkts und der Einspritzdauer erfolgt hierbei durch ein Steuersignal GROUP, das an einem Signaleingang 2 der Steuereinrichtung 1 anliegt und durch eine elektronische Motorsteuerung vorgegeben wird. Der Ladevorgang beginnt hierbei mit einer steigenden Flanke des Steuersignals GROUP, wohingegen eine fallende Flanke des Steuersignals GROUP den Entladevorgang einleitet, wie aus dem Impulsdiagramm in Figur 3 ersichtlich ist und noch detailliert beschrieben wird.

Die elektrische Aufladung des Aktors erfolgt in herkömmlicher Weise durch ein Schaltelement, das durch einen Signalausgang 3 der Steuereinrichtung 1 angesteuert wird, wobei das Schaltelement zur Vereinfachung nicht dargestellt ist.

An dem Signalausgang 3 erscheint hierbei ein binäres Steuersignal CHARGE, das bei einem High-Pegel eine Aufladung des Aktors bewirkt, während ein Low-Pegel des Steuersignals CHARGE den Ladevorgang beendet.

Zur Entladung des Aktors wird ein weiteres Schaltelement durch einen weiteren Signalausgang 4 mit einem binären Steuersignal DISCHARGE angesteuert, wobei ein High-Pegel des Steuersignals DISCHARGE die Entladung startet, während ein Low-Pegel des Steuersignals DISCHARGE die Entladung beendet.

Die Auf- bzw. Entladung des Aktors durch die beiden Schaltelemente erfolgt durch eine Transformatorschaltung, die beispielsweise in DE 199 44 733 A1 detailliert beschrieben ist, so dass deren Inhalt der vorliegenden Beschreibung in vollem Umfang zuzurechnen ist.

Die beiden Steuersignale CHARGE und DISCHARGE werden hierbei durch einen Zustandsautomaten 5 erzeugt, wobei nach dem Ende des Ladevorgangs zunächst eine vorgegebene Verzögerungszeit abgewartet wird, bis der Entladevorgang gestartet wird. Diese Verzögerung ist vorteilhaft, damit der zur Ansteuerung des Aktors eingesetzte Transformator vor Beginn des Entladevorgangs vollständig entleert ist.

Zur Verzögerung der Abgabe des Steuersignals DISCHARGE weist die Steuereinrichtung 1 ein Verzögerungsglied 6 auf, das ausgangsseitig mit dem Zustandsautomaten 5 verbunden ist und diesen mit einem binären Steuersignal GROUP_DELAYED ansteuert. Bei einem High-Pegel des Steuersignals GROUP_DELAYED gibt der Zustandsautomat 5 an dem Signalausgang 4 das Steuersignal DISCHARGE mit einem High-Pegel aus, wodurch der Entladevorgang sofort beginnt.

Weiterhin weist die Steuereinrichtung 1 einen Impulsgenerator 7 auf, der ein Taktsignal mit einer Frequenz von 4 MHz erzeugt.

Dieses Taktsignal wird einem Frequenzteiler 8 zugeführt, der die Frequenz des Taktsignals durch fünf teilt und ausgangsseitig eine Impulsfolge mit einer Frequenz von 800 kHz erzeugt, die als Referenzsignal für die Steuereinrichtung 1 verwendet wird.

Eingangsseitig weist der Frequenzteiler 8 einen Synchronisationseingang SYNC auf, dem das Steuersignal GROUP zugeführt wird. Die von dem Frequenzteiler 8 ausgangsseitig ausgegebene Impulsfolge wird also mit einer steigenden Flanke des Steuersignals GROUP synchronisiert. Durch diese Synchronisation wird der Jitter zwischen der steigenden Flanke des Steuersignals GROUP und dem tatsächlichen Beginn der Aufladung auf weniger als 250ns verringert. Dies ist insbesondere bei Direkteinspritzern vorteilhaft, um die Abgasemissionen zu verringern.

Ausgangsseitig ist der Frequenzteiler 8 mit dem Verzögerungsglied 6 sowie mit einem weiteren Frequenzteiler 9 verbunden, wobei der Frequenzteiler 9 die Aufgabe hat, die Verzögerungszeit für das Verzögerungsglied 6 variabel festzulegen.

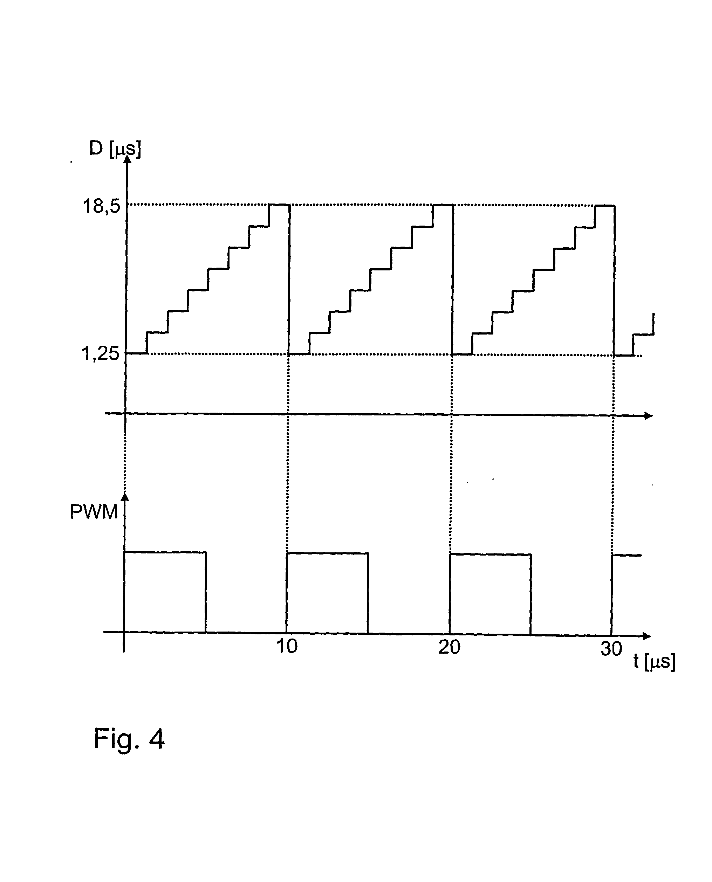

Der Frequenzteiler 9 erzeugt ausgangsseitig eine Impulsfolge PWM mit einer Frequenz von 100 kHz, die in dem Impulsdiagramm in Figur 3 oben sowie in dem Impulsdiagramm in Figur 4 unten dargestellt ist.

Die von dem Frequenzteiler 9 erzeugte Impulsfolge PWM wird hierbei mit dem Steuersignal GROUP synchronisiert, wobei eine steigende Flanke des Steuersignals GROUP mit einer steigenden Flanke der Impulsfolge PWM zusammenfällt. Der Frequenzteiler 9 weist deshalb einen Synchronisationseingang SYNC auf, der mit dem Signaleingang 2 der Steuereinrichtung 1 verbunden ist.

Ausgangsseitig ist der Frequenzteiler 9 mit dem Zustandsautomaten 5 verbunden, der beim Anliegen der Impulsfolge PWM den Lade- bzw. Entladevorgang durchführt.

Darüber hinaus ist der Frequenzteiler 9 auch mit einem Zähler 10 verbunden, der während des Lade- bzw. Entladevorgangs die Anzahl der Impulse der Impulsfolge PWM zählt.

Falls die Anzahl der von dem Zähler 10 erfassten Ladeimpulse beim Laden des Aktors einen vorgegebenen Maximalwert MAXCOUNT überschreitet, so gibt der Zähler 10 ein Abbruchsignal an den Zustandsautomaten 5, woraufhin dieser den Ladevorgang abbricht. Hierzu bringt der Zustandsautomat 5 das Steuersignal CHARGE an dem Steuerausgang 3 auf einen Low-Pegel, wodurch auch eine übermäßige Aufladung des Aktors verhindert wird. Typische Werte für den Maximalwert MAXCOUNT liegen im Bereich von 20 bis 30, was einer im Aktor gespeicherten Energie von 60 bis 90mJ entspricht.

Bei einem Entladevorgang zählt der Zähler 10 dann ausgehend von dem zuvor während der Ladephase ermittelten Zählwert abwärts die Anzahl der Entladeimpulse und gibt bei Null ebenfalls ein Abbruchsignal an den Zustandsautomaten 5, um den Entladevorgang zu beenden. Hierzu bringt der Zustandsautomat 5 das Steuersignal DISCHARGE an dem Signalausgang 4 auf einen Low-Pegel, woraufhin der Entladevorgang sofort beendet wird. Dieses Abwärtszählen der Entladeimpulse stellt sicher, dass die Anzahl der Entladeimpulse während des Entladevorgangs genauso groß ist wie die Anzahl der Ladeimpulse während des vorangegangenen Ladevorgangs, so dass der Aktor zum Großteil entladen ist, bevor er kurzgeschlossen wird. Eine vollkommene Entladung des Aktors ist nämlich eine Voraussetzung dafür, dass der Aktor während des folgenden Ladevorgangs auf ein definiertes Energieniveau gebracht werden kann.

Ferner weist die Steuereinrichtung noch eine Steuerschaltung 11 zur Ansteuerung mehrerer Auswahlschalter auf, die zur Vereinfachung nicht dargestellt sind. Die Auswahlschalter sind hierbei jeweils einem von mehreren Aktoren zugeordnet und ermöglichen eine brennraumselektive Auf- bzw. Entladung der Aktoren.

Schließlich ist der Frequenzteiler 9 noch mit einer herkömmlichen Stromregeleinheit 12 verbunden, die den primären und den sekundären Strom in der vorstehend erwähnten Transformatorschaltung regelt.

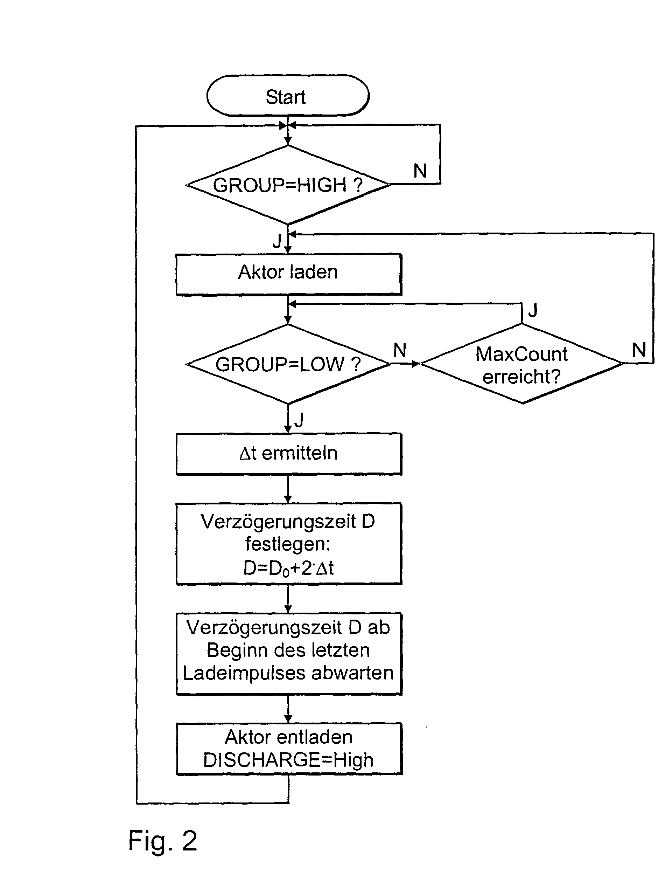

Im folgenden wird nun unter Bezugnahme auf die Impulsdiagramme in Figur 3 und das Flussdiagramm in Figur 2 die Funktionsweise der erfindungsgemäßen Steuereinrichtung 1 beschrieben.

Figur 3 zeigt insgesamt fünf Impulsdiagramme, wobei das obere Impulsdiagramm den zeitlichen Verlauf der von dem Frequenzteiler 9 erzeugten Impulsfolge PWM wiedergibt.

Die unteren Impulsdiagramme in Figur 3 geben dagegen den zeitlichen Verlauf der Aktorenergie E1 bzw. E2 für geringfügig unterschiedliche Steuersignale GROUP1 bzw. GROUP2 wieder.

Zum Zeitpunkt t=0 wird der Ladevorgang des Aktors durch eine steigende Flanke des Steuersignals GROUP1 bzw. GROUP2 eingeleitet. Dies führt zu einer Synchronisierung der Impulsfolge PWM durch den Frequenzteiler 9, so dass der Zustandsautomat 5 das Steuersignal CHARGE auf einen High-Pegel bringt, während das Steuersignal DISCHARGE einen Low-Pegel annimmt.

Während des Ladevorgangs gibt der Frequenzteiler 9 an seinem Ausgang COUNTER_STATE die Anzahl der Impulse seit Beginn des letzten Ladeimpulses aus, wobei diese Anzahl der Zeitspanne $\Delta t_1$ bzw. $\Delta t_2$ in Figur 3 entspricht.

Darüber hinaus zählt der Zähler 10 während des Ladevorgangs die Anzahl der Impulse und bricht den Ladevorgang beim Erreichen des vorgegebenen Maximalwerts MAX_COUNT ab, um eine übermäßige Aufladung des Aktors zu verhindern.

Bei einer fallenden Flanke des Steuersignals GROUP1 bzw. GROUP2 wird dann der Entladevorgang eingeleitet, wobei die Entladung zeitverzögert erfolgt, um sicherzustellen, das der Transformator der vorstehend erwähnten Transformatorschaltung zuvor vollständig entleert ist.

Hierzu übernimmt das Verzögerungsglied 6 bei einer fallenden Flanke des Steuersignals GROUP1 bzw. GROUP2 von dem Frequenzteiler 9 die Impulszahl COUNTER_STATE, die seit dem Beginn des letzten Ladeimpulses der Impulsfolge PWM gemessen wurde. Das Verzögerungsglied 6 bestimmt daraus die zugehörige Zeitspanne $\Delta t_1$ bzw. $\Delta t_2$ und berechnet eine Verzögerungszeit D1 bzw. D2 nach folgender Formel:

$$D = D_0 + 2 \cdot \Delta t.$$

Hierbei ist $D_0$=1,25 µs eine minimale Verzögerungszeit, die sicherstellen soll', das der Transformator der vorstehend erwähnten Transformatorschaltung vor Beginn des Entladevorgangs vollständig entladen ist. Die Verzögerungszeit D hängt also von der Zeitspanne $\Delta t_1$ bzw. $\Delta t_2$ zwischen der fallenden Flanke des Steuersignals GROUP1 bzw. GROUP2 als Entladesignal und dem Beginn des letzten Ladeimpulses der Impulsfolge ab, wobei die Abhängigkeit einen linearen Verlauf aufweist, die aus Figur 4 oben ersichtlich ist. Die Stufung des Verlaufs der Verzögerungszeit D in Figur 4 ergibt sich hierbei aus der Tatsache, dass der Frequenzteiler 9 mit einer Frequenz von 800 kHz angesteuert wird, während die Impulsfolge PWM nur eine Frequenz von 100 kHz aufweist.

Nach einer fallenden Flanke des Steuersignals GROUP1 bzw. GROUP2 zählt das Verzögerungsglied 6 dann die Anzahl der Impulse der von dem Frequenzteiler 8 erzeugten Impulsfolge und gibt das Steuersignals GROUP_DELAYED an den Zustandsautomaten 5 aus, wenn seit dem Beginn des vorangegangenen Ladeimpulses die Verzögerungszeit D verstrichen ist, wie aus Figur 3 ersichtlich ist. Der Zustandsautomat 5 bringt das Steuersignal DISCHARGE daraufhin auf einen High-Pegel, woraufhin der Entladevorgang unmittelbar beginnt.

Die erfindungsgemäße variable Festlegung der Verzögerungszeit D vor Beginn des Entladevorgangs bietet den Vorteil, dass der störende Einfluss der Zeitdiskretisierung bei der getakteten Auf- bzw. Entladung des Aktors verringert wird.

So können bei herkömmlichen Anordnungen mit einer konstanten Verzögerungszeit bereits geringfügige Verschiebungen der fallenden Flanke des Steuersignals GROUP als Entladesignal zu erheblichen Änderungen der Einspritzmenge führen. Dies ist dann der Fall, wenn das Entladesignal über eine Zeitdiskretisierungsgrenze hinweg verschoben wird, die in dem Impulsdiagramm in Figur 3 durch senkrechte gestrichelte Linien dargestellt ist. Bei einer derartigen Verschiebung des Entladesignals wird nämlich die Entladung um eine vollständige Zeitdiskretisierungseinheit verzögert, was in Figur 3 zu einem gestrichelt dargestellten Energieverlauf 13 führen würde.

Im Gegensatz dazu führt die flexible Festlegung der Verzögerungszeit D bei der erfindungsgemäßen Steuereinrichtung bei geringfügigen Verschiebungen des Entladesignals auch nur zu einer geringen Änderungen der Aktorenergie, die in Figur 3 durch eine schraffierte Fläche 14 dargestellt ist.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen.

**Patentansprüche**

1. Verfahren zur elektrischen Ansteuerung eines Aktors, mit den folgenden Schritten:

    - Aufladen des Aktors,
    - Abwarten einer vorgegebenen Verzögerungszeit (D1, D2),
    - Entladen des Aktors nach Ablauf der Verzögerungszeit (D1, D2), wobei die Verzögerungszeit (D1, D2) variabel festgelegt wird,

    **dadurch gekennzeichnet,**
    **dass** die Verzögerungszeit (D1, D2) in Abhängigkeit von der zeitlichen Lage eines Entladesignals festgelegt wird.

2. Verfahren nach Anspruch 1,
    **dadurch gekennzeichnet,**
    **dass** der Aktor durch eine Folge (PWM) von Ladeimpulsen aufgeladen wird, wobei die Verzögerungszeit (D1, D2) in Abhängigkeit von der Zeitspanne ($\Delta t_1$, $\Delta t_2$) zwischen dem Entladesignal und dem Beginn des vorangegangenen Ladeimpulses festgelegt wird.

3. Verfahren nach Anspruch 2,
    **dadurch gekennzeichnet,**
    **dass** die Verzögerungszeit (D1, D2) mit dem Beginn des vorangegangenen Ladeimpulses und/ oder eines Ladesignals anfängt.

4. Verfahren nach Anspruch 2 und/oder Anspruch 3,
    **dadurch gekennzeichnet,**
    **dass** die Verzögerungszeit (D1, D2) eine lineare Abhängigkeit von der Zeitspanne ($\Delta t_1$, $\Delta t_2$) zwischen dem Entladesignal und dem Beginn des vorangegangenen Ladeimpulses aufweist.

5. Verfahren nach mindestens einem der vorhergehenden Ansprüche,
    **dadurch gekennzeichnet,**
    **dass** die Verzögerungszeit (D1, D2) einen vorgegebenen Minimalwert aufweist.

**6.** Verfahren nach mindestens einem der vorhergehenden Ansprüche,
**dadurch gekennzeichnet,**
**dass** das Entladesignal eine fallende Flanke eines Steuersignals (GROUP) ist.

**7.** Verfahren nach mindestens einem der vorhergehenden Ansprüche,
**dadurch gekennzeichnet,**
**dass** der Aktor beim Auftreten eines Ladesignals aufgeladen wird.

**8.** Verfahren nach Anspruch 7,
**dadurch gekennzeichnet,**
**dass** das Ladesignal eine steigende Flanke eines Steuersignals (GROUP) ist.

**9.** Steuereinrichtung für einen Aktor, mit
einem Signaleingang (2) zur Aufnahme eines Entladesignals, einem Signalausgang (4) zur Abgabe eines Steuersignals (DISCHARGE) zum Entladen des Aktors, sowie mit
einem Verzögerungsglied (6) zur Verzögerung des Steuersignals (DISCHARGE) um eine vorgegebene Verzögerungszeit (D1, D2), wobei das Verzögerungsglied (6) eine variable Verzögerungszeit (D1, D2) aufweist,
**dadurch gekennzeichnet,**
**dass** die Verzögerungszeit (D1, D2) von der zeitlichen Lage des Entladesignals abhängig ist.

**10.** Steuereinrichtung nach Anspruch 9,
**dadurch gekennzeichnet,**
**dass** zur Erzeugung von Ladeimpulsen ein Impulsgeber (7) vorgesehen ist.

**11.** Steuereinrichtung nach Anspruch 10,
**dadurch gekennzeichnet,**
**dass** zur Ermittlung des Zeitabstands ($\Delta t_1$, $\Delta t_2$) zwischen dem Entladesignal und dem Beginn des vorangegangenen Ladeimpulses ein erster Zähler (9) vorgesehen ist, wobei der erste Zähler (9) ausgangsseitig mit dem Verzögerungsglied (6) verbunden ist, um die Verzögerungszeit (D1, D2) in Abhängigkeit von dem Zeitabstand ($\Delta t_1$, $\Delta t_2$) zwischen dem Entladesignal und dem Beginn des vorangegangenen Ladeimpulses festzulegen.

**12.** Steuereinrichtung nach mindestens einem der Ansprüche 9 bis 11,
**dadurch gekennzeichnet,**
**dass** das Verzögerungsglied (6) eingangsseitig mit dem Signaleingang (2) verbunden ist, um die Verzögerungszeit (D1, D2) bei einem Ladesignal zu starten.

**13.** Steuereinrichtung nach mindestens einem der Ansprüche 9 bis 12,

**dadurch gekennzeichnet,**
**dass** das Verzögerungsglied (6) einen zweiten Zähler aufweist, der eingangsseitig mit einem Impulsgeber (7) und mit dem Signaleingang (2) verbunden ist.

## Claims

**1.** Method for the electrical control of an actuator, comprising the following steps:

- charging of the actuator,
- waiting a predefined delay period (D1, D2),
- discharging of the actuator following expiration of said delay period (D1, D2), wherein the delay period (D1, D2) is specified variably,

**characterised in that**
the delay period (D1, D2) is specified as a function of the position in time of a discharge signal.

**2.** Method according to claim 1,
**characterised in that**
the actuator is charged by means of a sequence (PWM) of charge pulses, wherein the delay period (D1, D2) is specified as a function of the time span ($\Delta t_1$, $\Delta t_2$) between the discharge signal and the start of the preceding charge pulse.

**3.** Method according to claim 2,
**characterised in that**
the delay period (D1, D2) commences with the start of the preceding charge pulse and/or the start of a charge signal.

**4.** Method according to claim 2 and/or claim 3,
**characterised in that**
the delay period (D1, D2) has a linear dependency on the time span ($\Delta t_1$, $\Delta t_2$) between the discharge signal and the start of the preceding charge pulse.

**5.** Method according to at least one of the preceding claims,
**characterised in that**
the delay period (D1, D2) has a predefined minimum value.

**6.** Method according to at least one of the preceding claims,
**characterised in that**
the discharge signal is a falling edge of a control signal (GROUP) .

**7.** Method according to at least one of the preceding claims,
**characterised in that**
the actuator is charged when a charge signal occurs.

**8.** Method according to claim 7,
**characterised in that**
the charge signal is a rising edge of a control signal (GROUP).

**9.** Control device for an actuator, having
a signal input (2) for receiving a discharge signal,
a signal output (4) for delivering a control signal (DISCHARGE) for discharging the actuator, and having
a delay element (6) for delaying the control signal (DISCHARGE) by a predefined delay period (D1, D2),
wherein the delay element (6) has a variable delay period (D1, D2),
**characterised in that**
the delay period (D1, D2) is dependent on the position in time of the discharge signal.

**10.** Control device according to claim 9,
**characterised in that**
a pulse generator (7) is provided for generating charge pulses.

**11.** Control device according to claim 10,
**characterised in that**
a first counter (9) is provided for determining the time interval ($\Delta t_1$, $\Delta t_2$) between the discharge signal and the start of the preceding charge pulse, wherein said first counter (9) is connected on the output side to the delay element (6) in order to specify the delay period (D1, D2) as a function of the time interval ($\Delta t_1$, $\Delta t_2$) between the discharge signal and the start of the preceding charge pulse.

**12.** Control device according to at least one of the claims 9 to 11,
**characterised in that**
the delay element (6) is connected on the input side to the signal input (2) in order to start the delay period (D1, D2) when a charge signal occurs.

**13.** Control device according to at least one of the claims 9 to 12,
**characterised in that**
the delay element (6) has a second counter which is connected on the input side to a pulse generator (7) and to the signal input (2).

**Revendications**

**1.** Procédé pour la commande électrique d'un actionneur comprenant les étapes suivantes :

- charge de l'actionneur,

- attente d'un temps de retard donné (D1, D2),
- décharge de l'actionneur après la fin du temps de retard (D1, D2), le temps de retard (D1, D2) étant fixé de manière variable,

**caractérisé en ce que**
le temps de retard (D1, D2) est fixé en fonction de la position temporelle d'un signal de décharge.

**2.** Procédé selon la revendication 1,
**caractérisé en ce que**
l'actionneur est chargé par une série (PMW) d'impulsions de charge, le temps de retard (D1, D2) étant fixé en fonction de l'intervalle ($\Delta t_1$, $\Delta t_2$) entre le signal de décharge et le début de l'impulsion de charge précédente.

**3.** Procédé selon la revendication 2,
**caractérisé en ce que**
le temps de retard (D1, D2) commence avec le début de l'impulsion de charge précédente et/ou d'un signal de charge.

**4.** Procédé selon la revendication 2 et/ou la revendication 3,
**caractérisé en ce que**
le temps de retard (D1, D2) présente une dépendance linéaire de l'intervalle de temps ($\Delta t_1$, $\Delta t_2$) entre le signal de décharge et le début de l'impulsion de charge précédente.

**5.** Procédé selon au moins l'une quelconque des revendications précédentes,
**caractérisé en ce que**
le temps de retard (D1, D2) présente une valeur minimale donnée.

**6.** Procédé selon au moins l'une quelconque des revendications précédentes,
**caractérisé en ce que**
le signal de décharge est un flanc descendant d'un signal de commande (GROUP).

**7.** Procédé selon au moins l'une quelconque des revendications précédentes,
**caractérisé en ce que**
l'actionneur est chargé à l'apparition d'un signal de charge.

**8.** Procédé selon la revendication 7,
**caractérisé en ce que**
le signal de charge est un flanc ascendant d'un signal de commande (GROUP).

**9.** Dispositif de commande pour un actionneur comprenant une entrée de signal (2) pour recevoir un signal de décharge, une sortie de signal (4) pour émettre un signal de commande (DISCHARGE) pour décharger l'actionneur ainsi que d'un élément de temporisation (6) pour temporiser le signal de commande (DISCHARGE) suivant un temps de retard donné (D1, D2), l'élément de retard (6) présentant un temps de retard variable (D1, D2),

**caractérisé en ce que**

le temps de retard (D1, D2) dépend de la position temporelle du signal de décharge.

**10.** Dispositif de commande selon la revendication 9,

**caractérisé en ce qu'**

un émetteur d'impulsions (7) est prévu pour générer des impulsions de charge.

**11.** Dispositif de commande selon la revendication 10,

**caractérisé en ce qu'**

il est prévu un premier compteur (9) pour calculer l'intervalle de temps ($\Delta t_1$, $\Delta t_2$) entre le signal de décharge et le début de l'impulsion de charge précédente, le premier compteur (9) étant relié côté sortie à l'élément de temporisation (6) afin de déterminer le temps de retard (D1, D2) en fonction de l'intervalle ($\Delta t_1$, $\Delta t_2$) entre le signal de décharge et le début de l'impulsion de charge précédente.

**12.** Dispositif de commande selon au moins l'une des revendications 9 à 11,

**caractérisé en ce que**

l'élément de temporisation (6) est relié côté entrée à l'entrée de signal (2) afin de démarrer le temps de retard (D1, D2) pour un signal de charge.

**13.** Dispositif de commande selon au moins l'une des revendications 9 à 12,

**caractérisé en ce que**

l'élément de retard (6) présente un deuxième compteur qui est relié côté entrée à un émetteur d'impulsions (7) et à l'entrée de signal (2).

Fig. 1

EP 1 507 968 B1

```
                    ┌──────────────┐
                    │    Start     │
                    └──────────────┘
                           │
         ┌─────────────────┤
         │            ◇─────────────◇      N
         │           ◇   GROUP=HIGH ? ◇─────────┐
         │            ◇─────────────◇           │
         │                 │ J                  │
         │                 ▼                    │
         │          ┌──────────────┐            │
         │          │  Aktor laden │◄───────────┤
         │          └──────────────┘            │
         │                 │           J        │
         │                 ▼    ◄──────────┐    │
         │            ◇─────────────◇   N  ◇──────────────◇  N
         │           ◇  GROUP=LOW ? ◇─────◇   MaxCount     ◇──┘
         │            ◇─────────────◇      ◇   erreicht?   ◇
         │                 │ J             ◇──────────────◇
         │                 ▼
         │          ┌──────────────┐
         │          │  Δt ermitteln│
         │          └──────────────┘
         │                 │
         │                 ▼
         │          ┌──────────────┐
         │          │Verzögerungszeit D│
         │          │   festlegen: │
         │          │  D=D₀+2·Δt   │
         │          └──────────────┘
         │                 │
         │                 ▼
         │          ┌──────────────┐
         │          │Verzögerungszeit D ab│
         │          │ Beginn des letzten│
         │          │Ladeimpulses abwarten│
         │          └──────────────┘
         │                 │
         │                 ▼
         │          ┌──────────────┐
         │          │ Aktor entladen│
         │          │DISCHARGE=High│
         │          └──────────────┘
         │                 │
         └─────────────────┘
```

Verzögerungszeit D festlegen:
$$D = D_0 + 2 \cdot \Delta t$$

Fig. 2

Fig. 3

Fig. 4